# DEMANDE DE BREVET EUROPEEN

(11) **EP 4 815 224 A1**
(43) Date de publication de la demande: **30.09.2026**
(21) Numéro de dépôt: 26168121.7
(22) Date de dépôt: 26.03.2026
(51) Int. Cl.: H02B 1/20, H01F 38/28, G01R 15/18, H02B 1/14

(54) **INSTALLATION ÉLECTRIQUE POUR AÉRONEF COMPORTANT UN TRANSFORMATEUR DE COURANT POUR BARRE DE DISTRIBUTION ET AÉRONEF COMPORTANT UNE TELLE INSTALLATION**

(30) Priorité: 28.03.2025 FR 2503196
(71) Demandeur: Airbus Operations S.A.S., 31060 Toulouse (FR)
(72) Inventeur: DE KERGOMMEAUX, Matthieu, 31060 TOULOUSE (FR); BOISNIER, Benjamin, 31060 TOULOUSE (FR)
(74) Mandataire: Cabinet Le Guen Maillet

(57) **Abrégé**

L'invention concerne une installation électrique (1) pour aéronef (A) et qui comporte :
- une barre de distribution (11) électrique destinée à être fixée à un support (101) d'une armoire électrique ;
- un circuit imprimé (13) qui comporte un premier élément de connexion électrique (131) mâle ;
- un transformateur de courant (12) comportant :
- un corps (121) ;
- des moyens de fixation (123) destinés à fixer ledit corps audit support ; et
- un deuxième élément de connexion électrique (124) femelle destiné à coopérer avec ledit premier élément de connexion électrique dudit circuit imprimé ;

- un équipement (16) destiné à être raccordé électriquement à ladite barre de distribution.

L'invention propose donc une installation électrique qui permet de simplifier le câblage électrique global d'un aéronef tout en optimisant son encombrant. En effet, l'utilisation de barres de distribution permet de simplifier le câblage des armoires électriques et présente un encombrement plus faible qu'un câblage par des fils électriques classiques.

## Description

### DOMAINE TECHNIQUE

La présente invention concerne une installation électrique pour aéronef qui comporte un transformateur de courant destiné à être mis en œuvre sur une barre de distribution électrique (également connue sous le nom de barre omnibus ou barre bus) ainsi qu'un aéronef comportant une telle installation électrique.

### ÉTAT DE LA TECHNIQUE ANTÉRIEURE

Les aéronefs sont de manière générale équipés de faisceaux électriques comportant des câbles électriques C1 qui passent par des transformateurs T de courant généralement disposés dans des centrales ou armoires électriques. Certains de ces transformateurs peuvent par exemple être utilisés pour effectuer des mesures de courant. Avec l'augmentation des équipements électriques et électroniques embarqués dans les aéronefs, le nombre d'armoires électriques a augmenté, tout comme le nombre de câbles électriques C1 et de transformateurs T.

Un inconvénient de cette solution de l'art antérieur réside dans le fait que le câblage électrique global est complexe et encombrant. De plus, la fixation des câbles électriques C1 aux transformateurs T est chronophage pour les opérateurs et les opérations de maintenance (diagnostic de panne et réparation par exemple) sont complexes.

Ainsi, il existe donc un besoin de fournir une solution de câblage électrique qui répond au moins à certains de ces inconvénients. En particulier, il existe donc un besoin de fournir une solution de câblage électrique qui soit simple à mettre en œuvre, fiable et sécurisée pour les opérateurs notamment.

### EXPOSÉ DE L'INVENTION

Un objet de la présente invention est de proposer une installation électrique pour aéronef proposant une solution de câblage électrique qui soit notamment simple à mettre en œuvre, fiable et sécurisée pour les opérateurs.

À cet effet, est proposée une installation électrique pour aéronef comportant :
- une barre de distribution électrique destinée à être fixée à un support d'une armoire électrique ;
- un circuit imprimé comportant un premier élément de connexion électrique mâle ou femelle ; et
- un transformateur de courant comportant :
   - un corps comportant une ouverture traversante, où ladite barre de distribution est agencée pour traverser ladite ouverture traversante ;
   - des moyens de fixation destinés à fixer ledit corps audit support ; et
   - un deuxième élément de connexion électrique femelle ou mâle disposé dans ladite ouverture traversante et connecté électriquement audit premier élément de connexion électrique correspondant mâle ou femelle dudit circuit imprimé ;
- un équipement (16) destiné à être raccordé électriquement à ladite barre de distribution (11).

De cette manière, l'invention propose une solution qui permet de simplifier le câblage électrique global d'un aéronef tout en optimisant son encombrant. En effet, l'utilisation de barres de distribution électrique permet de simplifier le câblage des armoires électriques et présente un encombrement optimisé. De plus, le câblage électrique étant simplifié, les opérations de maintenance sont simplifiées. Une telle installation électrique permet également d'augmenter la fiabilité de l'installation.

Selon un aspect particulier de l'invention, ledit transformateur de courant comporte un dispositif de commutation configuré pour détecter si ledit équipement est raccordé électriquement à ladite barre de distribution.

Selon un premier exemple de réalisation de l'invention, ledit dispositif de commutation comporte un interrupteur mécanique et un capteur de proximité disposé dans ledit corps et à proximité de ladite ouverture traversante et dudit premier élément de connexion électrique.

Ledit interrupteur mécanique comporte :
- un capuchon monté mobile en translation dans ladite ouverture traversante dudit corps entre une position rétractée correspondant à une position dans laquelle ledit équipement est connecté électriquement à ladite barre de distribution, et une position déployée correspondant à une position dans laquelle ledit équipement n'est pas connecté électriquement à ladite barre de distribution ;

- un élément élastique solidaire dudit corps et dudit capuchon, où ledit élément élastique est configuré pour déplacer ledit capuchon de ladite position rétractée à ladite position déployée lorsque ledit équipement n'est pas connecté électriquement à ladite barre de distribution.

En particulier, ledit capteur de proximité est destiné à détecter lorsque ledit capuchon est dans ladite position rétractée et est configuré pour transmettre une information de raccordement électriquement dudit équipement vers une unité de commande de l'alimentation électrique de ladite barre de distribution.

Selon un deuxième exemple de réalisation de l'invention, ledit dispositif de commutation comporte un interrupteur mécanique et un contacteur électrique solidaire dudit deuxième élément de connexion électrique, où ledit interrupteur mécanique comporte :
- un capuchon monté mobile en translation dans ladite ouverture traversante dudit corps entre une position rétractée correspondant à une position dans laquelle ledit équipement est connecté électriquement à ladite barre de distribution, et une position déployée correspondant à une position dans laquelle ledit équipement n'est pas connecté électriquement à ladite barre de distribution, ledit capuchon comportant aussi un pion de commutation
- un élément élastique solidaire dudit corps et dudit capuchon, où ledit élément élastique est configuré pour déplacer ledit capuchon de ladite position rétractée à ladite position déployée lorsque ledit équipement n'est pas connecté électriquement à ladite barre de distribution.

En particulier, ledit contacteur électrique est destiné à coopérer avec ledit pion de commutation dudit capuchon lorsque ce dernier est en position rétractée et où ledit contacteur électrique est alors configuré pour transmettre un signal électrique vers une unité de commande de l'alimentation électrique de ladite barre de distribution correspondant au raccordement électriquement dudit équipement à la barre de distribution.

Selon un aspect particulier de l'invention, ledit interrupteur mécanique comporte en outre des moyens de maintien configurés pour maintenir ledit capuchon dans ladite ouverture traversante.

Selon encore un autre aspect particulier de l'invention, ledit capuchon comporte une partie principale de forme tubulaire dont une première extrémité comporte un rebord périphérique reçu dans ladite ouverture traversante, où ladite ouverture traversante comporte, à une première extrémité, une fente périphérique et, à une deuxième extrémité, un épaulement périphérique, où lesdits moyens de maintien comportent une rondelle de verrouillage disposée dans ladite fente périphérique et où ledit rebord périphérique dudit capuchon est destiné à se déplacer entre ledit épaulement périphérique de ladite ouverture traversante et ladite rondelle de verrouillage.

En outre, dans le deuxième exemple de réalisation, ledit capuchon comporte un pion de commutation qui s'étend à partir du rebord périphérique dans une direction opposée à ladite partie principale, ledit pion de commutation étant configuré pour traverser lesdits moyens de maintien pour coopérer avec ledit contacteur électrique lorsque ledit capuchon est en position rétractée.

Selon un aspect particulier de l'invention, ledit élément élastique est disposé entre ladite rondelle de verrouillage et ledit rebord périphérique dudit capuchon.

L'invention concerne également un aéronef comportant au moins une installation électrique telle que décrit précédemment.

### BRÈVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
[Fig. 1] est une vue de dessus d'un aéronef mettant en œuvre l'invention ;
[Fig. 2] est une vue en perspective et éclatée illustrant partiellement une installation électrique selon un premier exemple de réalisation de l'invention ;
[Fig. 3] est une vue en perspective et partiellement assemblée illustrant l'installation de la Fig. 2 ;
[Fig. 4] une vue de dessous et en coupe de l'installation de la Fig. 2 avec l'interrupteur en position déployée ;
[Fig. 5] une vue de dessous et en coupe de l'installation de la Fig. 2 avec l'interrupteur en position rétractée ;
[Fig. 6] une vue de dessous et en coupe d'une installation selon un deuxième exemple de réalisation, dans laquelle l'interrupteur est en position déployée ; et
[Fig. 7] une vue de dessous et en coupe de l'installation de la Fig. 6 avec l'interrupteur en position rétractée.

### EXPOSÉ DÉTAILLÉ D'UN EXEMPLE DE RÉALISATION

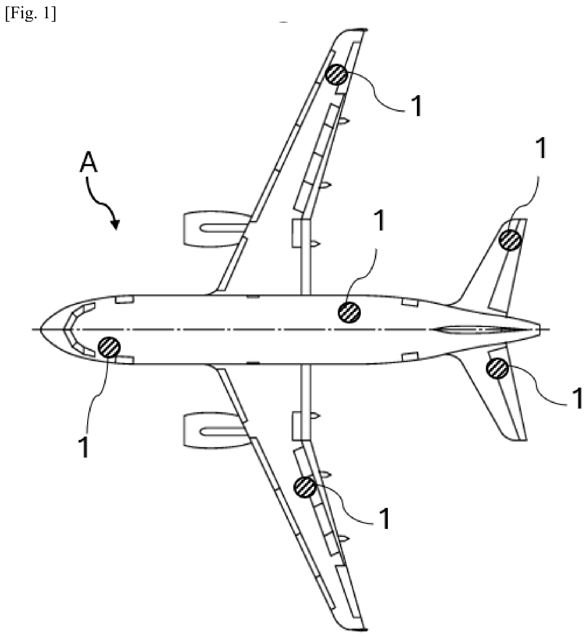

La Fig. 1 illustre en vue de dessus un aéronef A qui comporte au moins une installation électrique selon l'invention. L'usage d'une telle installation électrique dans un avion permet, comme décrit ci-après, d'optimiser l'encombrement d'une telle installation et de fournir une installation qui soit simple à mettre en œuvre, fiable et sécurisée pour les opérateurs.

Les Figs. 1 à 7 illustrent des exemples de réalisation d'une installation électrique 1 selon l'invention qui est destinée à être mise en œuvre dans un aéronef A. Contrairement à l'art antérieur, l'installation électrique 1 selon l'invention ne met plus en œuvre un faisceau électrique comportant une pluralité de câbles électriques mais elle met en œuvre un système de barres de distribution électrique.

Ainsi, l'installation électrique 1 comporte une barre de distribution 11 électrique destinée à être fixée à un support 101 d'une armoire électrique (non illustrée). La barre de distribution 11 peut être affleurante ou bien faire saillie par rapport au support 101 de l'armoire électrique. Le support 101 peut par exemple être un élément interne ou externe de l'armoire électrique. Il peut par exemple être fabriqué en métal ou en composite.

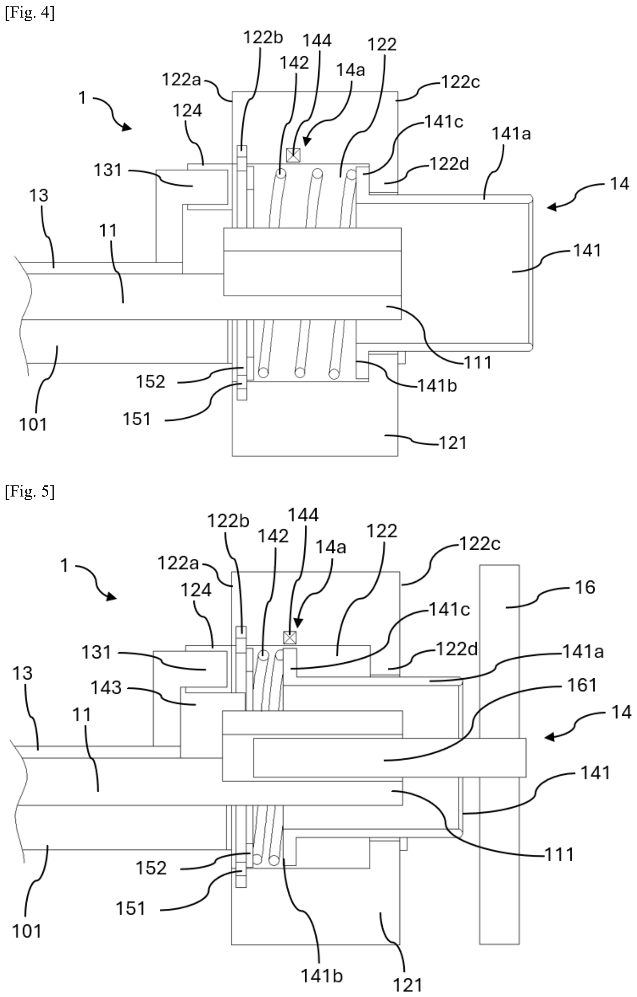

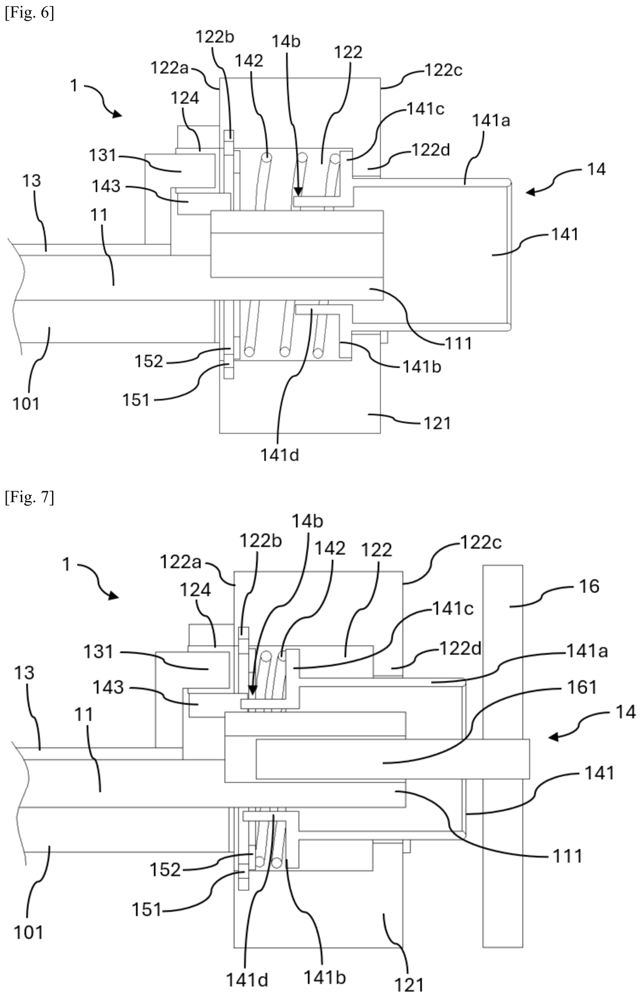

Un équipement 16, qui dans cet exemple se présente sous la forme d'une porte d'armoire électrique, est destiné à être raccordé électriquement à la barre de distribution 11. Ainsi, lorsque la porte 16 est raccordé électriquement à la barre de distribution 11, la barre de distribution 11 est destinée à alimenter électriquement la porte 16 d'armoire électrique (comme illustré schématiquement sur les Figs. 5 et 7) de sorte à faire fonctionner les éventuels composants/équipements électriques de cette porte 16.

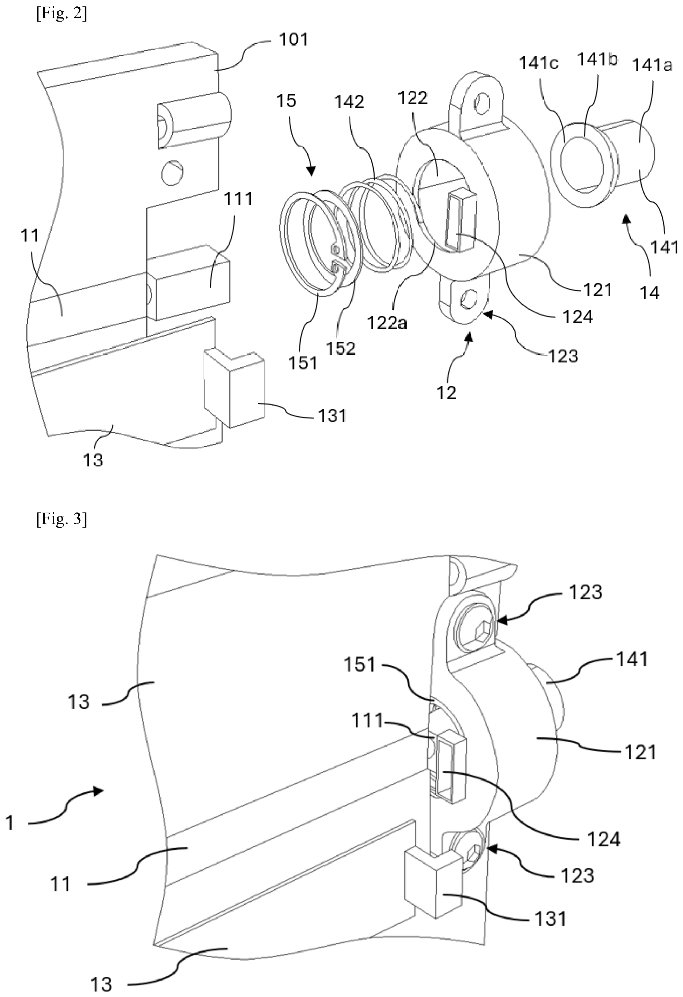

L'installation électrique 1 comporte en outre un circuit imprimé 13 qui comporte un premier élément de connexion électrique 131 mâle (ou femelle). Sur les Figs. 2 et 3, le premier élément de connexion électrique 131 n'est pas montré assemblé. Pour des raisons d'encombrement, le circuit imprimé 13 peut être fixé à ladite barre de distribution 11.

De plus, l'installation électrique 1 comporte un transformateur de courant 12 qui comporte un corps 121 présentant une ouverture traversante 122. Dans cet exemple, le corps 121 présente une forme globalement circulaire et l'ouverture traversante 122 présente également une forme circulaire. Ici, l'ouverture traversante 122 s'étend globalement coaxialement à l'axe longitudinal du corps 121. La barre de distribution 11 est agencée pour traverser l'ouverture traversante 122 du corps 121. De cette manière, le transformateur de courant 12 peut être utilisé pour mesurer le courant traversant la barre de distribution 11 lorsque la porte 16 est raccordée à la barre de distribution 11.

Le transformateur de courant 12 comporte des moyens de fixation 123 destinés à fixer le corps 121 au support 101. Dans cet exemple, le corps 121 présente des trous disposés dans des excroissances et les moyens de fixation 123 se présentent sous la forme d'une vis de fixation qui traverse les trous du corps 121 et qui est fixée dans le support 101 de l'armoire électrique. Bien évidemment, d'autres types de moyens de fixation 123 sont envisageables sans s'écarter du principe général de l'invention.

Le transformateur de courant 12 comporte en outre un deuxième élément de connexion électrique 124 femelle (ou mâle si le premier élément de connexion 131 du circuit imprimé est un élément femelle) disposé dans l'ouverture traversante 122. Le deuxième élément de connexion électrique 124 coopère avec le premier élément de connexion électrique 131 correspondant du circuit imprimé 13 de sorte à assurer une connexion électrique entre le transformateur de courant 12 et le circuit imprimé 13.

En particulier, le circuit imprimé 13 permet notamment de collecter les données de mesure du courant traversant dans la barre de distribution 11 qui sont relevées par le transformateur de courant 12. Ces données de mesure peuvent être remontées, grâce au circuit imprimé 13 vers un système de gestion (non illustré) de l'installation électrique 1. Comme détaillé ci-après, le circuit imprimé 13 peut également être utilisé pour transférer un signal indiquant l'état de la connexion entre la barre de distribution 11 et la porte 16 (par exemple afin de déterminer si la porte 16 de l'armoire électrique est ouverte ou fermée).

Il est ici fait référence à une seule barre de distribution 11 et un seul transformateur de courant 12 mais on comprend bien évidemment que l'installation électrique de l'invention peut comporter une pluralité de barres de distribution 11 et de transformateurs de courant 12. L'invention propose donc une installation électrique 1 qui permet de simplifier le câblage électrique global de l'aéronef A tout en optimisant son encombrant. En effet, l'utilisation de barres de distribution électrique permet de simplifier le câblage des armoires électriques et présente un encombrement plus faible qu'un câblage par des fils électriques classiques.

De plus, le câblage électrique étant simplifié, les opérations de maintenance (par exemple de diagnostic de panne ou de remplacement d'un transformateur de courant) sont simplifiées. Une telle installation électrique 1 permet également d'augmenter la fiabilité de l'installation puisque les risques de débranchement accidentel d'un câble électrique sont supprimés, tout comme les risques de court-circuit liés à un câble accidentellement dénudé.

De préférence, le transformateur de courant 12 comporte un dispositif de commutation 14a (Figs. 4 et 5) ou 14b (Figs. 6 et 7) configuré pour détecter si l'équipement 16 (ici la porte 16) est raccordé électriquement à la barre de distribution 11. En d'autres termes, le dispositif de commutation 14a, 14b agit tel un capteur pour déterminer si la porte 16 de l'installation électrique 1 est ouverte ou fermée, permettant ainsi d'alimenter ou non la barre de distribution 11 en électricité.

Selon le premier exemple de réalisation illustré sur les Figs. 2 à 5, le dispositif de commutation 14a comporte un interrupteur mécanique 14 et un capteur de proximité 144 qui est ici disposé dans le corps 121 et à proximité de l'ouverture traversante 122. De préférence encore, le capteur de proximité 144 est disposé à proximité du premier élément de connexion électrique 131 car c'est globalement à cet endroit que le capuchon (décrit ci-après) se situe lorsqu'il est dans la position rétractée. Le capteur de proximité 144 est connecté électriquement au circuit imprimé 13 de sorte que le circuit imprimé 13 puisse connaître l'état du capteur de proximité 144.

En particulier, l'interrupteur mécanique 14 comporte un capuchon 141 monté mobile en translation dans l'ouverture traversante 122 du corps 121 entre une position rétractée correspondant à une position dans laquelle la porte 16 est connectée électriquement à la barre de distribution 11, et une position déployée correspondant à une position dans laquelle la porte 16 n'est pas connectée électriquement à la barre de distribution 11. Dans cet exemple, le capuchon 141 présente une forme globalement tubulaire avec une section circulaire correspondant à la forme de l'ouverture traversante 122 du corps 121.

L'interrupteur mécanique 14 comporte également un élément élastique 142 solidaire du corps 121 et du capuchon 141. L'élément élastique 142, se présentant dans cet exemple sous la forme d'un ressort, est configuré pour déplacer le capuchon 141 de la position rétractée à la position déployée lorsque la porte 16 n'est pas connectée électriquement à la barre de distribution 11. En d'autres termes, l'élément élastique 142 exerce une force prédéterminée sur le capuchon 141 permettant de maintenir le capuchon 141 en position déployée ou, lorsque le capuchon 141 est en position rétractée, de déplacer le capuchon 141 vers la position déployée. Lorsqu'une force opposée et supérieure à la force prédéterminée exercée par l'élément élastique 142 est appliquée sur le capuchon 141, alors le capuchon 141 est déplacé de la position déployée à la position rétractée (cette force opposée peut par exemple être appliquée par un opérateur ou simplement par la porte 16 fermée de l'armoire électrique).

Le capteur de proximité 144 est destiné à détecter lorsque le capuchon 141 est dans la position rétractée, ce qui correspond à la position fermée de la porte 16 et donc au raccordement électrique de la porte 16 avec la barre de distribution 11. En d'autres termes, le capteur de proximité 144 est positionné de sorte que ce dernier soit capable de détecter lorsque le capuchon 141 est rétracté. Cette détection du capuchon 141 en position rétractée par le capteur de proximité 144 permet à ce dernier de transmettre une information de raccordement électrique de la porte 16 à la barre de distribution vers une unité de commande (non illustré) qui peut ensuite commander d'alimenter ou non la barre de distribution 11 en électricité. Ainsi, il est possible de détecter de manière simple et fiable si la porte 16 est raccordée électriquement à la barre de distribution 11 en fonction de la position du capuchon 141 mobile. L'unité de commande peut donc, dans le cas d'une détection d'une porte 16 ouverte (correspond à un non-raccordement électrique de la porte 16 à la barre de distribution 11) couper l'alimentation électrique de la barre de distribution 11 de sorte à assurer la sécurité d'un opérateur voulant effectuer une opération de maintenance de l'installation électrique 1. De plus, le capuchon 141 agit tel un élément de protection empêchant un contact direct avec la barre de distribution 11 sous tension, par exemple.

Plus précisément ici, la porte 16 comporte un élément de connexion 161 (se présentant par exemple sous la forme d'un goujon, d'une goupille, d'un axe ou autre) destiné à traverser le capuchon 141 et à coopérer avec un élément de connexion 111 correspondant porté par la barre de distribution 11. De cette manière, la barre de distribution 11 peut alimenter en électricité les éventuels composants/équipements électriques de la porte 16. Lorsque la porte 16 de l'armoire électrique (non illustrée sur la Fig. 4) est ouverte, le capuchon 141 est dans la position déployée (comme illustré sur la Fig. 4) car aucune force n'est appliquée sur ce dernier. L'élément élastique 142 repousse et maintient donc le capuchon 141 dans la position déployée. Il n'y a donc pas de coopération entre les éléments de connexion 161 de la porte 16 et 111 de la barre de distribution 11. Le capteur de proximité 144 détecte alors que la porte 16 n'est pas connectée électriquement à la barre de distribution 11 et cette information peut être transmise par le circuit imprimé 13 vers l'unité de commande de sorte à ce que l'alimentation électrique de la barre de distribution soit coupée, permettant ainsi l'intervention d'un opérateur sans danger, par exemple.

Lorsque la porte est fermée (comme illustré sur la Fig. 5), le capuchon 141 est dans la position rétractée car la porte 16 appuie sur le capuchon 141 et le déplace de sa position déployée à sa position rétractée. L'élément de connexion 161 de la porte 16 coopère donc avec l'élément de connexion 111 de la barre de distribution 11. De plus, le capteur de proximité 144 détecte le capuchon 141 (ce qui n'est pas le cas dans la position déployée du capuchon 141) et donc la connexion électrique entre la porte 16 et la barre de distribution 11 et transmet cette information à l'unité de commande qui peut rétablir l'alimentation électrique de la barre de distribution 11.

Selon un autre exemple de réalisation, illustré sur les Figs 6 et 7, le dispositif de commutation 14b comporte un interrupteur mécanique 14 et un contacteur électrique 143 solidaire du deuxième élément de connexion électrique 124. Ce deuxième exemple de réalisation se distingue donc de l'exemple de réalisation précédemment décrit en ce qu'il ne comporte pas de capteur de proximité 144 mais un contacteur électrique 143. Ainsi, l'interrupteur 14 est sensiblement identique à celui du premier exemple de réalisation, dans sa structure et ses fonctions, et ne sera donc pas décrit en détails de nouveau.

Dans ce deuxième exemple de réalisation, le capuchon 141 comporte un pion de commutation 141d qui est destiné à coopérer avec le contacteur électrique 143 lorsque le capuchon 141 est en position rétractée. Le contacteur électrique 143 est en particulier configuré pour transmettre un signal électrique, indiquant le raccordement électriquement de la porte 16 à la barre de distribution 11, vers l'unité de commande (qui peut dans cet exemple se présenter simplement sous la forme d'un contacteur d'alimentation) qui commande l'alimentation électrique de la barre de distribution 11. Ce signal électrique permet d'activer le contacteur électrique de sorte que l'alimentation en électricité de la barre de distribution soit effective uniquement lorsque la porte 16 est raccordée électriquement à la barre de distribution, c'est-à-dire uniquement lorsque le capuchon 141 est dans la positon rétractée et que le pion de commutation 141d coopère avec le contacteur électrique 143.

Comme précédemment, il est ainsi possible de détecter de manière simple et fiable si la porte 16 est raccordée électriquement à la barre de distribution 11 en fonction de la position du capuchon 141 mobile. L'unité de commande peut donc, dans le cas d'une détection d'une porte 16 ouverte (correspond à un non-raccordement électrique de la porte 16 à la barre de distribution 11) couper l'alimentation électrique de la barre de distribution 11 de sorte à assurer la sécurité d'un opérateur voulant effectuer une opération de maintenance de l'installation électrique 1. Ici encore, le capuchon 141 agit tel un élément de protection empêchant un contact direct avec la barre de distribution 11 sous tension, par exemple. Comme précédemment, la porte 16 comporte un élément de connexion 161 destiné à traverser le capuchon 141 et à coopérer avec un élément de connexion 111 correspondant porté par la barre de distribution 11. La barre de distribution 11 peut ainsi alimenter en électricité les éventuels composants/équipements électriques de la porte 16. Lorsque la porte 16 de l'armoire électrique (non illustrée sur la Fig. 6) est ouverte, le capuchon 141 est dans la position déployée (comme illustré sur la Fig. 6) car aucune force n'est appliquée sur ce dernier. L'élément élastique 142 repousse et maintient donc le capuchon 141 dans la position déployée. Il n'y a donc pas de coopération entre les éléments de connexion 161 de la porte 16 et 111 de la barre de distribution 11. Le contacteur électrique 143 n'étant pas activé, cela indique que la porte 16 n'est pas connectée électriquement à la barre de distribution 11 et aucun signal électrique correspondant au raccordement électrique de la porte 16 à la barre de distribution n'est alors transmis vers l'unité de commande par le circuit imprimé 13. Ainsi, l'alimentation électrique de la barre de distribution 11 est coupée, permettant ainsi l'intervention d'un opérateur sans danger, par exemple.

Lorsque la porte est fermée (comme illustré sur la Fig. 7), le capuchon 141 est dans la position rétractée car la porte 16 appuie sur le capuchon 141 et le déplace de sa position déployée à sa position rétractée. L'élément de connexion 161 de la porte 16 coopère donc avec l'élément de connexion 111 de la barre de distribution 11, de même que le pion de commutation 141d coopère avec le contacteur électrique 143. Ainsi, un signal de raccordement de la porte 16 à la barre de distribution 11 peut être transmis du contacteur électrique 143 vers l'unité de commande via le circuit imprimé 13 de sorte que l'unité de commande puisse rétablir l'alimentation électrique de la barre de distribution 11.

Dans ces exemples de réalisation, l'interrupteur 14 agit comme un élément de détection de l'ouverture de la porte 16 ainsi qu'un élément de protection qui permet de couper l'alimentation électrique de la barre de distribution 11 de sorte à éviter tout risque d'accident. Comme illustré sur les Figs. 2 à 7, l'interrupteur mécanique 14 comporte en outre des moyens de maintien 15 configurés pour maintenir le capuchon 141 dans l'ouverture traversante 122 tout en permettant son déplacement entre les positions déployée et rétractée.

Plus précisément, le capuchon 141 comporte une partie principale 141a de forme globalement tubulaire dont une première extrémité 141b (située du côté opposé à la porte 16) comporte un rebord périphérique 141c reçu dans l'ouverture traversante 122. L'ouverture traversante 122 comporte, à une première extrémité 122a, une fente périphérique 122b et, à une deuxième extrémité 122c, un épaulement périphérique 122d.

Les moyens de maintien 15 comportent une rondelle de verrouillage 151 (qui se présente ici sous la forme d'un circlip de sorte à faciliter son installation) disposée dans la fente périphérique 122b. Ainsi, le rebord périphérique 141c du capuchon 141 peut se déplacer dans l'ouverture traversante 122 entre l'épaulement périphérique 122d de l'ouverture traversante 122 et la rondelle de verrouillage 151. L'épaulement périphérique 122d et la rondelle de verrouillage 151 forment donc des butées pour limiter le déplacement du capuchon 141 au sein de l'ouverture traversante 122.

Il s'agit donc d'une solution technique relativement simple à mettre en œuvre qui garantit un maintien optimal du capuchon 141 dans l'ouverture traversante 122 sans gêner le déplacement de ce dernier.

Dans cet exemple, l'élément élastique 142 est donc disposé entre la rondelle de verrouillage 151 et le rebord périphérique 141c du capuchon 141 de sorte à pouvoir pousser le capuchon 141 de la position rétractée à la position déployée, par exemple lors de l'ouverture de la porte 16 de l'armoire.

Dans cet exemple, les moyens de maintien 15 comportent optionnellement une rondelle additionnelle 152 intercalée entre la rondelle de verrouillage 151 et l'élément élastique 142 de sorte que la force de l'élément élastique 142 ne soit pas appliquée directement contre la rondelle de verrouillage 151.

En référence à l'interrupteur 14 du deuxième exemple de réalisation illustré sur les Figs. 6 et 7, le capuchon 141 présente un pion de commutation 141d qui s'étend à partir du rebord périphérique 141c dans une direction opposée à la partie principale 141a. En d'autres termes, le pion de commutation141d s'étend globalement coaxialement à la partie principale 141a, mais de l'autre côté du rebord 141c. Le pion de commutation 141d est configuré pour traverser les moyens de maintien 15 (et en particulier la rondelle de verrouillage 151) pour coopérer ensuite avec le contacteur électrique 143 lorsque le capuchon 141 est en position rétractée (comme illustré sur la Fig. 7).

## Revendications

1. Installation électrique (1) pour aéronef (A), ladite installation (1) comportant :
- une barre de distribution (11) électrique destinée à être fixée à un support (101) d'une armoire électrique ;
- un circuit imprimé (13) comportant un premier élément de connexion électrique (131) mâle ou femelle ; et
- un transformateur de courant (12) comportant :
- un corps (121) comportant une ouverture traversante (122), où ladite barre de distribution (11) est agencée pour traverser ladite ouverture traversante (122) ;
- des moyens de fixation (123) destinés à fixer ledit corps (121) audit support (101) ; et
- un deuxième élément de connexion électrique (124) femelle ou mâle disposé dans ladite ouverture traversante (122) et connecté électriquement audit premier élément de connexion électrique (131) correspondant mâle ou femelle dudit circuit imprimé (13)
- un équipement (16) destiné à être raccordé électriquement à ladite barre de distribution (11).

2. Installation électrique (1) selon la revendication 1, **caractérisée en ce que** ledit transformateur de courant (12) comporte un dispositif de commutation (14a, 14b) configuré pour détecter si ledit équipement (16) est raccordé électriquement à ladite barre de distribution (11).

3. Installation électrique (1) selon la revendication 2, **caractérisée en ce que** ledit dispositif de commutation (14a) comporte un interrupteur mécanique (14) et un capteur de proximité (144) disposé dans ledit corps (121) et à proximité de ladite ouverture traversante (122) et dudit premier élément de connexion électrique (131),
où ledit interrupteur mécanique (14) comporte :
- un capuchon (141) monté mobile en translation dans ladite ouverture traversante (122) dudit corps (121) entre une position rétractée correspondant à une position dans laquelle ledit équipement (16) est connecté électriquement à ladite barre de distribution (11), et une position déployée correspondant à une position dans laquelle ledit équipement (16) n'est pas connecté électriquement à ladite barre de distribution (11) ;
- un élément élastique (142) solidaire dudit corps (121) et dudit capuchon (141), où ledit élément élastique (142) est configuré pour déplacer ledit capuchon (141) de ladite position rétractée à ladite position déployée lorsque ledit équipement (16) n'est pas connecté électriquement à ladite barre de distribution (11) ;
et où ledit capteur de proximité (144) est destiné à détecter lorsque ledit capuchon (141) est dans ladite position rétractée et est configuré pour transmettre une information de raccordement électrique dudit équipement (16) vers une unité de commande de l'alimentation électrique de ladite barre de distribution (11).

4. Installation électrique (1) selon la revendication 2, **caractérisée en ce que** ledit dispositif de commutation (14b) comporte un interrupteur mécanique (14) et un contacteur électrique (143) solidaire dudit deuxième élément de connexion électrique (124)
où ledit interrupteur mécanique (14) comporte :
- un capuchon (141) monté mobile en translation dans ladite ouverture traversante (122) dudit corps (121) entre une position rétractée correspondant à une position dans laquelle ledit équipement (16) est connecté électriquement à ladite barre de distribution (11), et une position déployée correspondant à une position dans laquelle ledit équipement (16) n'est pas connecté électriquement à ladite barre de distribution (11), où ledit capuchon (141) comporte un pion de commutation (141d) ;
- un élément élastique (142) solidaire dudit corps (121) et dudit capuchon (141), où ledit élément élastique (142) est configuré pour déplacer ledit capuchon (141) de ladite position rétractée à ladite position déployée lorsque ledit équipement (16) n'est pas connecté électriquement à ladite barre de distribution (11) ;
et où ledit contacteur électrique (143) est destiné à coopérer avec ledit pion de commutation (141d) dudit capuchon lorsque ce dernier est en position rétractée et où ledit contacteur électrique (143) est alors configuré pour transmettre un signal électrique vers une unité de commande de l'alimentation électrique de ladite barre de distribution (11) indiquant le raccordement électriquement dudit équipement (16) à la barre de distribution (11).

5. Installation électrique (1) selon la revendication 3 ou 4, **caractérisée en ce que** ledit interrupteur mécanique (14) comporte en outre des moyens de maintien (15) configurés pour maintenir ledit capuchon (141) dans ladite ouverture traversante (122).

6. Installation électrique (1) selon la revendication 5, **caractérisée en ce que** ledit capuchon (141) comporte une partie principale (141a) de forme tubulaire dont une première extrémité (141b) comporte un rebord périphérique (141c) reçu dans ladite ouverture traversante (122), **en ce que** ladite ouverture traversante (122) comporte, à une première extrémité (122a), une fente périphérique (122b) et, à une deuxième extrémité (122c), un épaulement périphérique (122d),
**en ce que** lesdits moyens de maintien (15) comportent une rondelle de verrouillage (151) disposée dans ladite fente périphérique (122b) et **en ce que** ledit rebord périphérique (141c) dudit capuchon (141) est destiné à se déplacer entre ledit épaulement périphérique (122d) de ladite ouverture traversante (122) et ladite rondelle de verrouillage (151),
et **en ce que** ledit capuchon (141) comporte, lorsqu'il est mis en œuvre, un pion de commutation (141d) qui s'étend à partir du rebord périphérique (141c) dans une direction opposée à ladite partie principale (141a), ledit pion de commutation (141d) étant configuré pour traverser lesdits moyens de maintien (15) pour coopérer avec ledit contacteur électrique (143) lorsque ledit capuchon (141) est en position rétractée.

7. Installation électrique (1) selon la revendication 6, **caractérisée en ce que** ledit élément élastique (142) est disposé entre ladite rondelle de verrouillage (151) et ledit rebord périphérique (141c) dudit capuchon (141).

8. Aéronef (A) comportant au moins une installation électrique (1) selon l'une des revendications 1 à 7.
